# EUROPÄISCHE PATENTSCHRIFT

(11) **EP 1 792 348 B1**
(45) Veröffentlichungstag und Bekanntmachung des Hinweises auf die Patenterteilung: **12.03.2014**
(21) Anmeldenummer: 05779024.8
(22) Anmeldetag: 11.08.2005
(51) Int. Cl.: H01L 31/18, H01L 21/368, C23C 18/00, C30B 29/10

(54) **VERFAHREN ZUM AUFBRINGEN EINER ZINKSULFID-PUFFERSCHICHT AUF EIN HALBLEITERSUBSTRAT MITTELS CHEMISCHER BADABSCHEIDUNG, INSBESONDERE AUF DIE ABSORBERSCHICHT EINER CHALKOPYRIT-DÜNNSCHICHT-SOLARZELLE**
METHOD FOR APPLICATION OF A ZINC SULPHIDE BUFFER LAYER TO A SEMICONDUCTOR SUBSTRATE BY MEANS OF CHEMICAL BATH DEPOSITION IN PARTICULAR ON THE ABSORBER LAYER OF A CHALCOPYRITE THIN-FILM SOLAR CELL
PROCEDE POUR APPLIQUER UNE COUCHE TAMPON DE SULFURE DE ZINC SUR UN SUBSTRAT SEMICONDUCTEUR PAR DEPOT EN BAIN CHIMIQUE, EN PARTICULIER SUR LA COUCHE ABSORBANTE D'UNE CELLULE SOLAIRE EN COUCHES MINCES A BASE DE CHALCOPYRITE

(30) Priorität: 18.08.2004 DE 102004040546
(43) Veröffentlichungstag der Anmeldung: 06.06.2007
(73) Patentinhaber: Helmholtz-Zentrum Berlin für Materialien und Energie GmbH, 14109 Berlin (DE)
(72) Erfinder: ENNAOUI, Ahmed, 13469 Berlin (DE); FLORIAN, Timo (geb. Kropp), 12207 Berlin (DE); LUX-STEINER, Martha Christina, 14163 Berlin (DE)
(86) Internationale Anmeldenummer: PCT/DE2005/001431
(87) Internationale Veröffentlichungsnummer: WO 2006/018013

(56) Entgegenhaltungen:
- JOHNSTON D A ET AL: "Chemical bath deposition of zinc sulfide based buffer layers using low toxicity materials" PREPARATION AND CHARACTERIZATION, ELSEVIER SEQUOIA, NL, Bd. 403-404, 1. Februar 2002 (2002-02-01), Seiten 102-106, XP004430335 ISSN: 0040-6090
- BAOSHENG SANG ET AL: "Investigation of chemical-bath-deposited ZnS buffer layers for Cu(InGa)Se2 thin film solar cells" CONFERENCE RECORD OF THE 29TH IEEE PHOTOVOLTAIC SPECIALISTS CONFERENCE, Bd. CONF. 29, 19. Mai 2002 (2002-05-19), Seiten 632-635, XP010666379 ISBN: 0-7803-7471-1
- DONA J M ET AL: "PROCESS AND FILM CHARACTERIZATION OF CHEMICAL-BATH-DEPOSITED ZNS THIN FILMS" JOURNAL OF THE ELECTROCHEMICAL SOCIETY, ELECTROCHEMICAL SOCIETY. MANCHESTER, NEW HAMPSHIRE, US, Bd. 141, Nr. 1, Januar 1994 (1994-01), Seiten 205-210, XP000445647 ISSN: 0013-4651
- NAKADA T ET AL: "High-efficiency Cu(In,Ga)Se2 thin-film solar cells with a CBD-ZnS buffer layer" SOLAR ENERGY MATERIALS AND SOLAR CELLS, ELSEVIER SCIENCE PUBLISHERS, AMSTERDAM, NL, Bd. 67, Nr. 1-4, März 2001 (2001-03), Seiten 255-260, XP004224768 ISSN: 0927-0248
- NAKADA T ET AL: "Band offset of high efficiency CBD-ZnS/CIGS thin film solar cells" PREPARATION AND CHARACTERIZATION, ELSEVIER SEQUOIA, NL, Bd. 431-432, 1. Mai 2003 (2003-05-01), Seiten 242-248, XP004428645 ISSN: 0040-6090
- VIDAL J ET AL: "Influence of magnetic field and type of substrate on the growth of ZnS films by chemical bath" PREPARATION AND CHARACTERIZATION, ELSEVIER SEQUOIA, NL, Bd. 419, Nr. 1-2, 1. November 2002 (2002-11-01), Seiten 118-123, XP004391118 ISSN: 0040-6090

## Beschreibung

Die Erfindung betrifft ein Verfahren zum Aufbringen einer Zinksulfid-Pufferschicht auf ein Halbleitersubstrat mittels chemischer Badabscheidung, insbesondere auf die Absorberschicht einer Chalkopyrit-Dünnschicht-Solarzelle. Das Verfahren lässt sich beispielsweise auch für die Herstellung von II-VI "superstrat" Dünnschicht-Solarzellen und Chalkopyrit "superstrat" Dünnschicht-Solarzellen anwenden.

In neuerer Zeit werden große Anstrengungen zur Entwicklung kostengünstiger Solarzellen gemacht. Dabei stellen Chalkopyrit-Dünnschicht-Solarzellen den jüngsten Entwicklungsstand dar. Hierbei werden Schichten aus Kupfer und Indium auf ein Substrat aufbracht. Wahlweise kann auch Gallium hinzugefügt werden. Dieses wird dann mit Selen und/oder Schwefel umgesetzt (CIS, CIGS oder CIGSSe, allgemein "CIS-Solarzellen"). Unter den Dünnschicht-Technologien ist die CIS-Technologie wegen ihrer Umweltverträglichkeit und ihrer niedrigeren Kosten besonders interessant.

Die Solarzellen werden hergestellt, indem zunächst eine elektrisch leitende Schicht, in der Regel eine aufgesputterte Molybdänschicht, auf Floatglas oder Sodalimglas und nachfolgend CIS, CIGS oder CIGSSe üblicherweise im Hochvakuum von weniger als 3 µm Dicke aufgebracht wird. Auf diese Absorberschicht wird üblicherweise eine Pufferschicht aus Cadmiumsulfid aufgebracht. Als Deckschicht wird wiederum eine transparente und leitfähige Schicht aufgebracht, die so genannte Fensterschicht. Für die Erzeugung von Modulen wird der Absorber auf strukturiertes Glas-Molybdänsubstrat aufgebracht und ebenfalls nach der Aufbringung der Pufferschicht strukturiert, so dass eine elektrische Verschaltung entsteht. Durch Kontaktierung und Rahmung der gesamten Struktur entsteht ein Dünnschicht-Solarmodul, das zur Umwandlung von Lichtenergie in elektrische Leistung dient.

Es sind wegen der Nachteile von Glas als Substrat auch verschiedene Anstrengungen unternommen worden, um statt Glas flexible Materialien einsetzen zu können. So sind auch Solarmodule bekannt, bei denen als Substrat ein metallisches Band verwendet wird. Ebenfalls bekannt geworden sind Kunststoff-Folien zur CIS-Abscheidung. Angeregt wurde auch bereits ein elektrolytisches Aufbringen der CIS-Schicht.

Damit aber eine solche Dünnschicht-Solarzelle effizient arbeiten kann, benötigt man eine Pufferschicht zwischen der Absorber-Schicht (z.B. Cu(InₐGa_{b})(SₓSe_{y})) und der Fensterschicht(i-ZnO/ZnO:Ga). Diese schützt die Oberfläche vor Beschädigungen, die beim Auftragen der Fensterschicht entstehen können. Des Weiteren sorgt sie für eine Oberflächendotierung der Absorber-Schicht, sowie einer Passivierung der Oberfläche um niedrigere Oberflächenzustände zu erhalten. Um diese sehr dünne Pufferschicht auftragen zu können, kommen die drei üblichen Verfahren Sputtern, Aufdampfen oder (elektro)chemische Abscheidung in Frage. Sputtern oder Aufdampfen verlangen beide einen hohen apparativen Aufwand. Am günstigsten erweist sich bisher die chemische Badabscheidung (Chemical Bath Deposition - CBD), bei der bisher Cadmiumsulfid (CdS) abgeschieden wird. Außerdem liefert nur die CBD eine dünne, homogene und konforme Bedeckung unterhalb von 50 nm.

Da Cadmium ein sehr giftiges Schwermetall ist, wurde bereits nach Alternativen gesucht. So lässt sich statt Cadmiumsulfid auch Zinksulfid (ZnS) verwenden, das sich ebenfalls mit chemischer Badabscheidung aufbringen lässt, siehe z.B. Nakada et al., Polycristalline (Cu(In,Ga)Se₂ Thin Film Solar Cells with Chemically Deposited Sulfide (CdS,ZnS) Buffer Layers, 2nd World Conference and Exhibition on Photovoltaic Solar Energy Conversion, 6-10 July 1998, Wien.

Verfahren zur chemischen Badabscheidung von Zinksulfid haben jedoch nur bei gleichzeitiger Verwendung von Hydrazin gute Abscheideraten. Zinksulfid wird hierbei beispielsweise aus einer Lösung aus Zinkacetat, Thioharnstoff, Ammoniak und Hydrazin abgeschieden, siehe z.B. Neve et al., ERDA analysis of ZnSx(OH)y thin films obtained by chemical bath deposition, Mat. Res. Symp.Proc. Vol 668, 2001 Materials Research Society, H5.3.1 - H5.3.6 oder Ennaoui et al., Highly efficient Cu(Ga,In)(S,Se)2 thin film solar cells with zinc-compound buffer layers, Thin Solid Films 431-432 (2003), S. 335-339. Nach der Untersuchung von Neve et al. kann Ammoniak auch weggelassen werden, Hydrazin ist jedoch unbedingt notwendig. Da jedoch Hydrazin (N₂H₄) als giftig und krebsauslösend eingestuft wird, hat dieses Verfahren keinen großen ökologischen Vorteil. Siehe Herrero et al. Journal of Electrochemical Society, Vol 142, No. 3, 1995, S. 764-770.

In JP 3249342 B ist ein Verfahren zur Herstellung einer ZnS-Schicht mittels chemischer Badabscheidung beschrieben, wobei die dabei verwendete chemische Badlösung mindestens aus Zinksulfat, Ammoniumhydroxid und Thioharnstoff in dieser Reihenfolge gebildet wird. Das hierbei entstehende Zinkhydroxid ist ein unerwünschtes Zwischenprodukt.

Aufgabe der vorliegenden Erfindung ist es deshalb, ein weiteres Verfahren zum Aufbringen einer Zinksulfid-Pufferschicht auf ein Halbleitersubstrat anzugeben, das ebenfalls ohne giftige oder umweltgefährdende Zusätze auskommt und einen vergleichbaren bzw. günstigeren apparativen und zeitlichen Aufwand hat wie dem Stand der Technik nach bekannte Verfahren und bei dem Zinkhydroxid nicht als Zwischenprodukt entsteht.

Erfindungsgemäß wird die Aufgabe gelöst durch die Merkmale des Anspruchs 1. Zweckmäßige Ausgestaltungen sind Gegenstand der Unteransprüche.

Danach wird nach Auflösen von Zinksulfat in destilliertem Wasser bei einer Temperatur von 70 °C - 90 °C nachfolgend Thioharnstoff zugegeben. Die Konzentration von Zinksulfat (C_{ZnSO4}) sollte 0,05 - 0,5 mol/l und die Konzentration von Thioharnstoff (C_{SC(NH2)2}) 0,2 - 1,5 mol/l betragen. Anschließend wird konzentrierter Ammoniak (25 %ig) hinzugegeben (ca. 1/3 der Wassermenge). Es bildet sich ein weißer Niederschlag, der sich durch Rühren zunächst wieder auflösen muss. Das Halbleitersubstrat wurde vor dem eigentlichen Abscheiden mit einer Ammoniak/Wasser-Lösung behandelt. Nun folgt für etwa 10 Minuten das Tauchen in das chemische Bad, dessen Temperatur in dieser Zeit konstant gehalten wird. Während der gesamten Zeit wird die Lösung kontinuierlich gerührt.

Überraschend hat sich gezeigt, dass sich allein durch eine andere Reihenfolge der Reaktionen zwischen den drei beteiligten Stoffen Zinksulfat, Thioharnstoff und Ammoniak und bestimmte Prozessbedingungen ein völlig geändertes Abscheideverhalten von Zinksulfid ergibt, indem im Unterschied zu dem von Nakada et al. angegebenen Verfahren (s.o.) erst die Zinkionen mit dem Thioharnstoff reagieren (komplexiert werden) und erst danach die Zugabe von Ammoniak erfolgt, welches dann mit den verbleibenden Zinkionen ebenfalls reagiert (komplexiert). Thioharnstoff wirkt hierbei nun als Komplexierungsmittel und als Quelle der Sulfidionen.

Es bildet sich eine gleichmäßig dicke Schicht aus Zinksulfid. Zur Erzielung höherer Schichtdicken kann das Verfahren mehrmals wiederholt werden.

Die Substrate werden zweckmäßig anschließend in einer Ammoniak/WasserLösung gespült und im Stickstoffgasstrom getrocknet.

Abschließend erfolgt noch für eine bestimmte Zeit eine Temperung in Luft zwischen 100 °C und 180 °C.

Nach anschließendem Aufbringen der Fensterschicht erhält man die fertige Zelle.

Auf CulnS₂-Solarzellen bezogen sind Wirkungsgrade über 10 % (aktiver Bereich) erreichbar.

Das erfindungsgemäße Verfahren hat für CulnS₂-Solarzellen die folgenden Vorteile:
- Mit der ZnS-Schicht ist es erstmals möglich, vergleichbare bzw. höhere Wirkungsgrade zu erzielen als es sie zur Zeit nur mit giftigen Cadmiumverbindungen möglich sind. Das Verfahren ist somit bei gleichem Erfolg sehr viel umweltfreundlicher.
- Die Abscheidung erfolgt in einem Arbeitsschritt (nur ein einziger, zehnminütiger Zyklus), so dass der Prozess auch einfach zu automatisieren ist.
- Die Abscheidung dauert nicht länger als mit herkömmlichen Verfahren. Es werden Abscheideraten von 1-2 nm/min erreicht.
   Gerade die dickeren Schichten sind sehr homogen und kompakt, so sind auch Zellen ohne eine darüber liegende i-ZnO-Schicht möglich.
- Es kann ohne größeren Umbau derselbe apparative Aufbau wie bisher verwendet werden. Auch ein "upscaling" ist einfach umzusetzen.
- Die Zinksulfid-Pufferschicht hat gegenüber einer Cadmiumsulfid-Schicht den Vorteil, dass sie eine höhere Bandlücke aufweist und deshalb in einem größeren Spektralbereich wirksam ist und so eine höhere Stromausbeute liefert.

Als Nebenprodukt liefert das Verfahren hochwertiges ZnS/ZnO-Pulver, das anderweitig weiterverwendet werden kann.

Das Verfahren soll nachstehend anhand eines Ausführungsbeispiels noch näher erläutert werden. In den zugehörigen Zeichnungen zeigen:
Fig. 1 eine Versuchsanordnung zum Beschichten einer Probe,
Fig. 2 die erreichte Quantenausbeute einer Probe und
Fig. 3 die Strom-Spannungs-Kurve einer Probe.

Für eine Chalkopyrit-Dünnschicht-Solarzelle (kein Modul) wurde beispielsweise folgender Schichtenaufbau gewählt:
Substrat: Glas
Rückwärtige Kontaktschicht: Molybdän
Absorber: CulnS₂
Pufferschicht: ZnS
Fensterschicht: i-ZnO / ZnO:Ga
Lichtseitige Kontaktierung: NiAl

Für das Aufbringen von ZnS auf Chalkopyritabsorbern werden die Proben 1 vor der chemischen Badabscheidung in einer Wasser/Ammoniak-Lösung aufbewahrt.

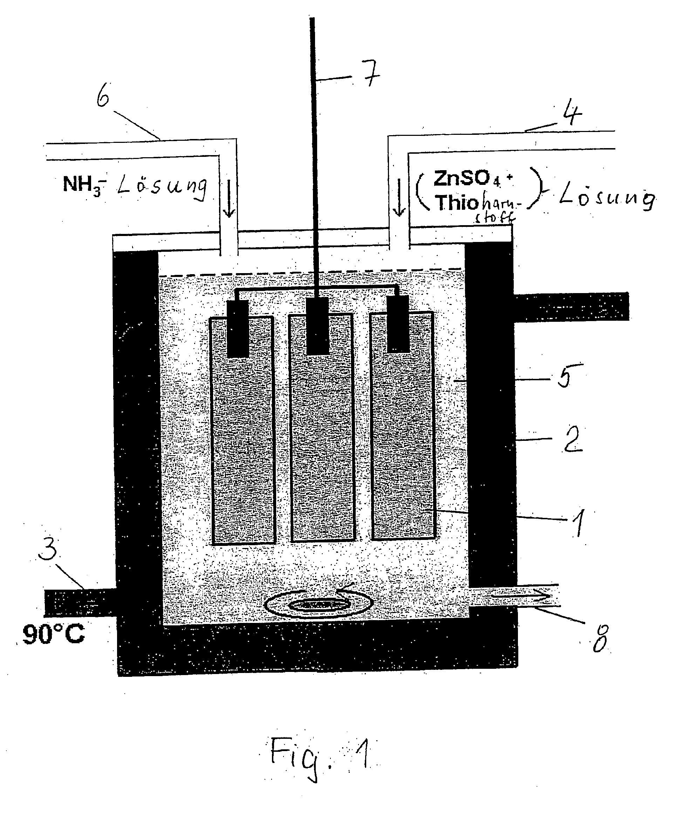

Fig. 1 zeigt den Versuchsaufbau. Benutzt wurde ein Probengefäß 2, das mit einer Heizung 3 ausgerüstet ist.

Das in Figur 1 schematisch gezeigte chemische Bad wird wie folgt hergestellt:
1) Es wird eine heiße Lösung (70-90 °C) mit 0,05 bis 0,5 mol/l Zinksulfat und 0,2 bis 1,5 mol/l Thioharnstoff (SC(NH₂)₂) aus doppelt destilliertem Wasser hergestellt (angedeutet durch den Zulauf 4).
2) Diese Lösung wird eine Zeit lang weiter gerührt.
3) Dann gibt man NH₃-Lösung (25 %ig) hinzu (angedeutet durch den Zulauf 6). Man beobachtet sofort einen weißen Niederschlag, der sich durch fortgesetztes Rühren wieder auflöst. Es entsteht eine völlig klare Lösung mit einem pH-Wert von 10 bis 11.
4) Die Proben 1 werden in einem Probenhalter 7 fixiert und eingetaucht. Während der Abscheidung wird die Lösung weiter gerührt und die Temperatur weiter gehalten.
5) Nach ca. 10 min werden die Proben 1 entnommen, die anfangs klare Lösung beginnt sich einzutrüben.
6) Die Proben 1 werden mit einer Wasser/Ammoniak-Lösung gewaschen und in einem Stickstoffstrom getrocknet.
7) Die entstehende Schichtdicke auf dem Absorber der Proben 1 beträgt ca. 10-15 nm.
8) Das Verfahren kann wiederholt werden, um dickere Filmschichten zu erreichen. Drei Zyklen ergeben etwa eine Schichtdicke von 60 nm. Auf eine Spülung und Trocknung kann zwischen den Zyklen verzichtet werden.
9) Die beschichteten Proben 1 werden nun bei 100-180 °C in Luft für eine bestimmte Zeit auf einer Heizplatte getempert.

Die Reaktion läuft vermutlich folgendermaßen ab:

Zn²⁺ + n TU = [Zn(TU)ₙ]²⁺ (1)

Bei Zugabe von NH₃ bildet sich aus überschüssigem Zn²⁺ ein zweiter Komplex

Zn²⁺ + 4NH₃ = [Zn(NH₃)₄]²⁺ (2)

Die Dissoziation der Zn-Komplexe aus Reaktion (1) und (2) liefern freie Zn-Kationen.

Thioharnstoff (TU) wirkt als ein Komplexbildner ebenso wie als Quelle für die Sulfid-Ionen.

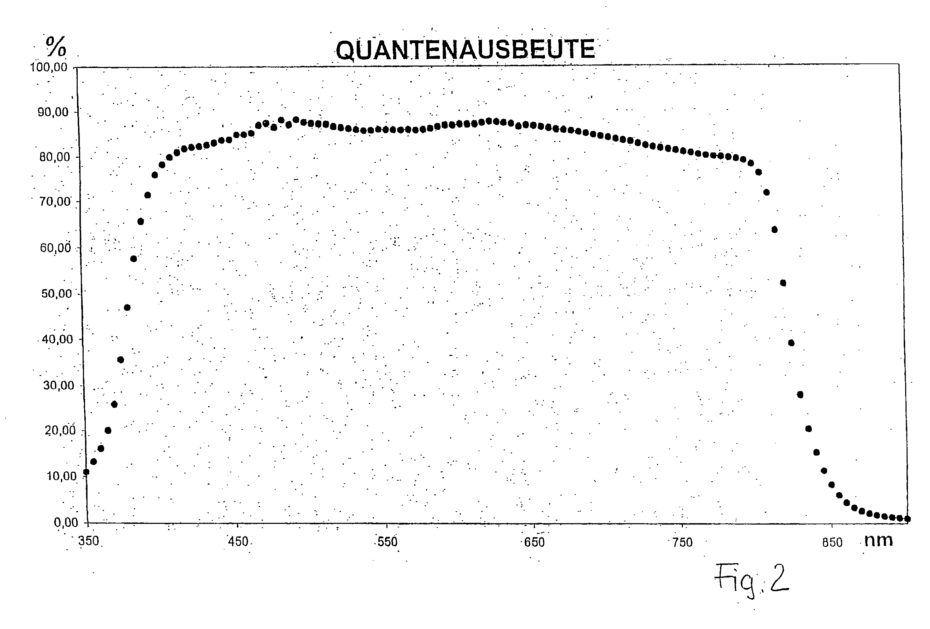

Figur 2 zeigt die mit der Probe erreichte Quantenausbeute (Verhältnis von erzeugten Ladungen zur eingebrachten Lichtleistung).

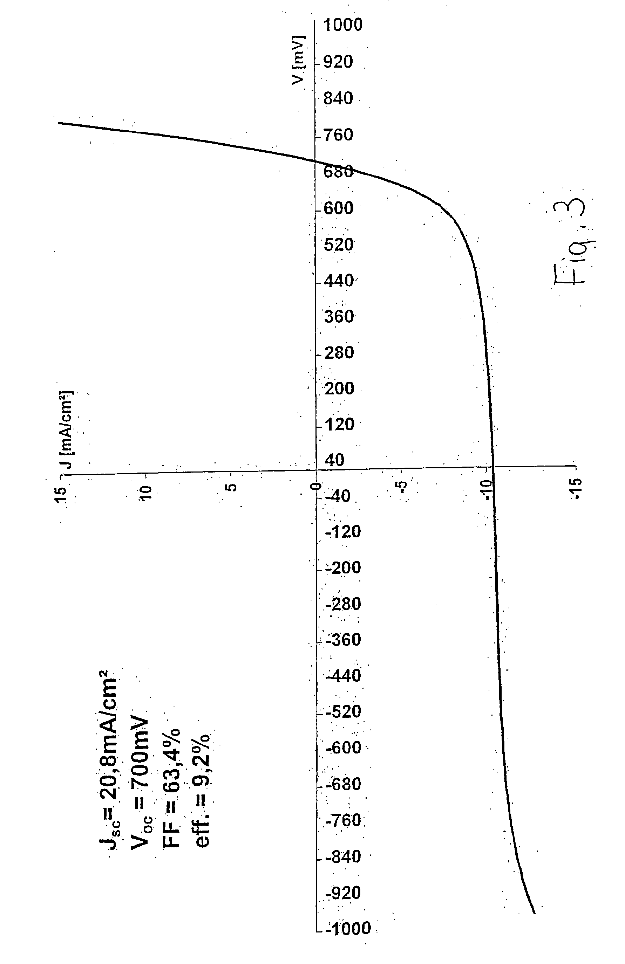

Die erreichten Wirkungsgrade lagen bei 10,5 % (im photovoltaisch aktiven Bereich). Figur 3 zeigt die Strom-Spannungs-Kurve einer im Sonnensimulator (AM 1,5/100 mW/cm²) gemessenen Solarzelle. Die Kurzschlussstromdichte lag bei 22,7 mA/cm² (bezogen auf den aktiven Bereich) und die Leerlaufspannung V_{oc} bei 700 mV. Der Füllfaktor (Verhältnis des Produkts von Strom und Spannung bei einem Arbeitspunkt zum Produkt von Kurzschlussstrom I_{sc} und Leerlaufspannung V_{oc}) ist mit 65 % sehr hoch.

## Patentansprüche

1. Verfahren zum Aufbringen einer Zinksulfid-Pufferschicht auf ein Halbleitersubstrat mittels chemischer Badabscheidung, wobei die chemische Badlösung mindestens aus Zinksulfat, Ammoniumhydroxid und Thioharnstoff gebildet wird, **gekennzeichnet durch** die folgenden Schritte in der angegebenen Reihenfolge:
- Auflösen von 0,05 bis 0,5 mol/l Zinksulfat und 0,2 bis 1,5 mol/l Thioharnstoff in destilliertem Wasser bei einer Temperatur von 70 °C bis 90 °C,
- Zugabe von 25 %-igem Ammoniak in Höhe eines Drittels der Menge des destillierten Wassers,
- nach Klarwerden der so erhaltenen Badlösung für 10 Minuten Tauchen des Halbleitersubstrat in die Badlösung, deren erreichte Temperatur in dieser Zeit konstant gehalten wird.

2. Verfahren nach Anspruch 1, **dadurch gekennzeichnet, dass** es zum Aufbringen einer dickeren Zinksulfid-Pufferschicht mindestens einmal wiederholt wird.

3. Verfahren nach Anspruch 1 oder 2, **dadurch gekennzeichnet, dass** die Badlösung fortwährend gerührt wird.

4. Verfahren nach Anspruch 1 oder 2, **dadurch gekennzeichnet, dass** das Halbleitersubstrat vor dem Tauchen mit einer Ammoniak/Wasser-Lösung behandelt, und nach dem Tauchen mit einer Ammoniak/Wasser-Lösung gespült, mit Stickstoff getrocknet wird und anschließend bei 100 bis 180 °C getempert wird.

## Claims

1. A method for application of a zinc sulphide buffer layer to a semiconductor substrate by means of chemical bath deposition, wherein the chemical bath solution is at least formed from zinc sulphate, ammonium hydroxide and thiourea, **characterized by** the following steps in the sequence indicated:
- dissolution of 0.05 to 0.5 mol/l zinc sulphate and 0.2 to 1.5 mol/I thiourea in distilled water at a temperature of 70 °C to 90 °C,
- addition of 25 % ammonia in the proportion of one-third of the quantity of the distilled water,
- once the bath solution thereby obtained has become clear, immersion of the semiconductor substrate in the bath solution for 10 minutes, the temperature of said bath solution reached being kept constant during this time.

2. The method according to claim 1, **characterized in that** it is repeated at least once for application of a thicker zinc sulphide buffer layer.

3. The method according to claim 1 or 2, **characterized in that** the bath solution is continuously agitated.

4. The method according to claim 1 or 2, **characterized in that** the semiconductor substrate is treated with an ammonia/water solution prior to immersion and is rinsed with an ammonia/water solution following immersion, dried using nitrogen and then tempered at 100 to 180 °C.

## Revendications

1. Procédé pour l'application d'une couche tampon de sulfure de zinc sur un substrat semi-conducteur par dépôt en bain chimique, la solution du bain étant créée au moins à partir de sulfate de zinc, d'hydroxyde d'ammonium et de thio-urée, **caractérisé par** les étapes suivantes, dans l'ordre chronologique indiqué :
- dissolution de 0,05 à 0,5 mol/l de sulfate de zinc et de 0,2 à 1,5 mol/l de thio-urée dans de l'eau distillée, à une température de 70°C à 90°C,
- ajout d'ammoniac à 25 %, à raison d'un tiers de la quantité d'eau distillée,
- après limpidification de la solution du bain ainsi obtenue, pendant 10 minutes, immersion du substrat semi-conducteur dans la solution du bain, dont la température atteinte est maintenue constante pendant ce laps de temps.

2. Procédé selon la revendication 1, **caractérisé en ce qu'**on le répète au moins une fois pour appliquer une couche tampon de sulfure de zinc plus épaisse.

3. Procédé selon la revendication 1 ou la revendication 2, **caractérisé en ce qu'**on agite constamment la solution du bain.

4. Procédé selon la revendication 1 ou la revendication 2, **caractérisé en ce qu'**avant l'immersion, on traite le substrat semi-conducteur avec une solution eau/ammoniac et après l'immersion, on le rince avec une solution eau/ammoniac, on le sèche à l'azote et on le tempère ensuite à de 100 à 180 °C.
